# EUROPEAN PATENT APPLICATION

(11) **EP 2 413 370 A2**
(43) Date of publication of application: **01.02.2012**
(21) Application number: 11157815.9
(22) Date of filing: 11.03.2011
(51) Int. Cl.: H01L 31/0224, H05K 3/12

(54) **Solar cell and electrode structure therefor**

(30) Priority: 28.07.2010 TW 099214419
(71) Applicant: Neo Solar Power Corp., Hsinchu City 300 (TW)
(72) Inventor: Wu, Meng-Hsiu, 300, Hsinchu City (TW); Tai, Yu-Wei, 300, Hsinchu City (TW); Chen, Yang-Fang, 300, Hsinchu City (TW)
(74) Representative: 2K Patentanwälte Blasberg Kewitz & Reichel

(57) **Abstract**

An electrode structure for a solar cell is disposed on a substrate of the solar cell. The electrode structure includes a plurality of bus electrodes and a plurality of finger electrodes. The bus electrodes are formed by separately disposing a conductive material on the substrate. The finger electrodes are formed by separately disposing a conductive material on the substrate and at two sides of the bus electrodes. The bus electrodes and the finger electrodes are formed by two screen printing processes. The bottom portion of the finger electrodes are formed by a first screen printing process, and the top portion of the finger electrodes and the bus electrodes are formed by a second screen printing process. Therefore, the electrode structure can enhance the conductivity of electrodes and increase the reliability and yield of the solar cell, thereby achieving the purposes of increasing the photo-electro transition efficiency of the solar cell and decreasing the manufacturing cost.

## Description

### BACKGROUND OF THE INVENTION

### Field of Invention

The present invention relates to an electrode structure and, in particular, to a solar cell and an electrode structure thereof.

### Related Art

The solar energy is one of the potential renewable energy technologies, and it has the advantages of no generation of CO₂, and almost no pollution and noise. Accordingly, it is desired to decrease the cost of utilizing the solar energy to be competitive with other electricity generation technologies. However, the expenses of the solar energy technology include the costs for the solar cell module, frame, transformer, and land for installing the solar cell, so that the total cost is very expensive. Therefore, to increase the performance of the solar cell and decrease the cost have become important issues for marketing the solar energy technology.

Using the screen printing technology to manufacture the electrode structure of the solar cell can efficiently decrease the manufacturing cost and time of the solar cell. In addition, the screen printing technology for forming the electrode structure usually uses the silver gel to form the bus electrodes and finger electrodes.

In order to enhance the photo-electro transition efficiency of the solar cell, the obscuring rate of the solar light caused by the bus electrodes should be decreased. Thus, the surface area of the substrate covered by the bus electrodes is preferably smaller. However, in order to transmit enough electron flow, the sufficient contact area between the electrodes and the substrate must be provided. It is desired to achieve the above requirements for enhancing the photo-electro transition efficiency without decreasing the conductivity of the electrodes. In general, two screen printing processes are used to form the narrower and higher bus electrodes, and the two screen printing processes are ideally form the overlapped patterns, which are accurately aligned. However, if the align error of the overlapped patterns is too large, the width of the formed bus electrode will be too wide, which may result in the bad photo-electro transition of the solar cell. Moreover, the more precise screen printing machine and finer screen ruling are necessary for reducing the alignment error. However, to provide the desired screen printing machine and screen ruling always increases the manufacturing cost.

Therefore, it is an important subject of the present invention to improve the conventional two screen printing technology so as to increase the conductivity of the electrodes as well as the reliability and yield of the solar cell, thereby achieving the purposes of increasing the photo-electro transition efficiency of the solar cell and decreasing the manufacturing cost thereof.

### SUMMARY OF THE INVENTION

In view of the foregoing subject, an objective of the present invention is to provide a solar cell and an electrode structure thereof that can increase the conductivity of the electrodes as well as the reliability and yield of the solar cell, thereby increasing the photo-electro transition efficiency of the solar cell and decreasing the manufacturing cost thereof.

To achieve the above objective, the present invention discloses an electrode structure of a solar cell. The electrode structure is disposed on a substrate of the solar cell and includes a plurality of bus electrodes and a plurality of finger electrodes. The bus electrodes are formed by separately disposing a conductive material on the substrate. The finger electrodes are formed by separately disposing a conductive material on the substrate and at two sides of the bus electrodes. The bus electrodes and the finger electrodes are formed by two screen printing processes. The bottom portion of the finger electrodes are formed by a first screen printing process, and the top portion of the finger electrodes and the bus electrodes are formed by a second screen printing process.

To achieve the above objective, the present invention also discloses a solar cell including a substrate, a plurality of bus electrodes and a plurality of finger electrodes. The bus electrodes are formed by separately disposing a conductive material on the substrate. The finger electrodes are formed by separately disposing a conductive material on the substrate and at two sides of the bus electrodes. The bus electrodes and the finger electrodes are formed by two screen printing processes. The bottom portion of the finger electrodes are formed by a first screen printing process, and the top portion of the finger electrodes and the bus electrodes are formed by a second screen printing process.

In one aspect of the present invention, the material used in the first screen printing process is different from that used in the second screen printing process. Preferably, the conductivity of the material used in the second screen printing process is larger than that of the material used in the first screen printing process. Preferably, the penetrability of the material used in the first screen printing process is larger than that of the material used in the second screen printing process.

In one aspect of the present invention, the materials used in the first screen printing process and the second screen printing process comprise silver particles and glass powder.

In one aspect of the present invention, the substrate is an amorphous silicon substrate, a single-crystal silicon substrate, a poly-crystal silicon substrate, or an As-Ga substrate.

In one aspect of the present invention, the substrate is an N-type semiconductor substrate or a P-type semiconductor substrate.

As mentioned above, in the electrode structure of the solar cell of the present invention, the first and second screen printing processes can form different patterns. The first screen printing process forms the bottom portions of a plurality of finger electrodes. After solidifying the bottom portions of the finger electrodes, the second screen printing process forms the bus electrodes and the top portions of the finger electrodes and then solidifies the bus electrodes and the top portions of the finger electrodes. Preferably, the material used in the first screen printing process is different from that used in the second screen printing process. In one embodiment of the present invention, the conductivity of the material used in the second screen printing process is larger than that of the material used in the first screen printing process. In addition, the penetrability of the material used in the first screen printing process is larger than that of the material used in the second screen printing process. Accordingly, the bottom portions of the finger electrodes formed by the first screen printing process can properly penetrate the anti-reflective layer of the substrate after high-temperature sintering, and the bus electrodes and the top portions of the finger electrodes formed by the second screen printing process can only contact with the anti-reflective layer of the substrate and not penetrate it. Compared with the conventional two screen printing processes that both form the same patterns of electrodes, the solar cell and the electrode structure of the present invention can have enhanced reliability against the environment and conductivity of the bus electrodes. The present invention can also decrease the defect of the solar cell. Thus, the purposes of increasing the photo-electro transition efficiency of the solar cell and decreasing the manufacturing cost thereof can be achieved.

### BRIEF DESCRIPTION OF THE DRAWINGS

The invention will become more fully understood from the detailed description and accompanying drawings, which are given for illustration only, and thus are not limitative of the present invention, and wherein:

FIG. 1 is a schematic diagram showing a solar cell and an electrode structure thereof according to an embodiment of the present invention;

FIG. 2 is a flow chart of a manufacturing method of the electrode structure of the solar cell according to the embodiment of the present invention;

FIG. 3 is a schematic diagram showing the screen used in the first screen printing process of the present invention; and

FIG. 4 is a schematic diagram showing the screen used in the second screen printing process of the present invention.

### DETAILED DESCRIPTION OF THE INVENTION

The present invention will be apparent from the following detailed description, which proceeds with reference to the accompanying drawings, wherein the same references relate to the same elements.

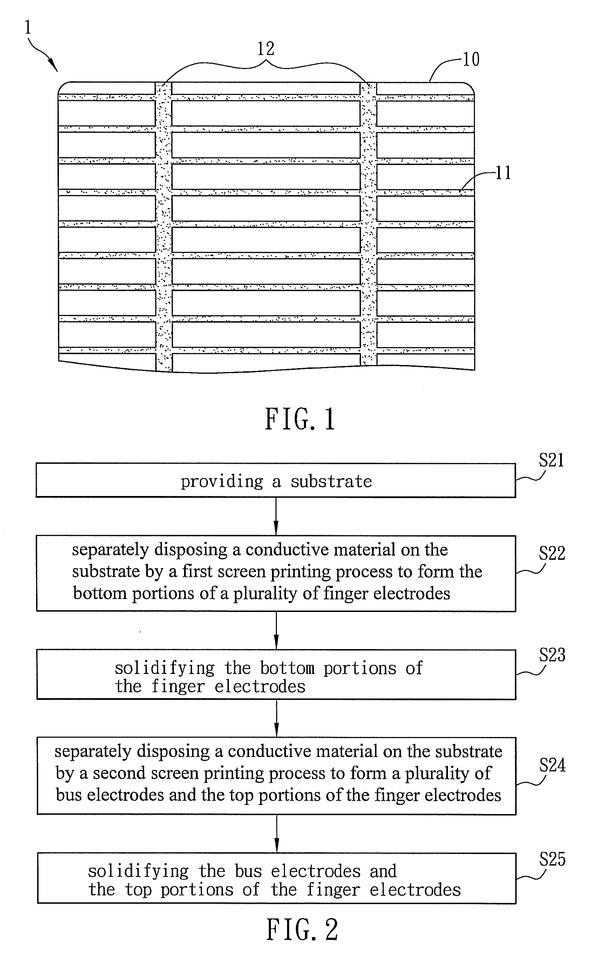

FIG. 1 is a schematic diagram showing a solar cell 1 and an electrode structure thereof according to an embodiment of the present invention. The solar cell 1 includes a substrate 10, a plurality of bus electrodes 12, and a plurality of finger electrodes 11. The solar cell 1 can be a silicon-based solar cell or a thin-film solar cell. The substrate 10 can be an amorphous silicon substrate, a single-crystal silicon substrate, a poly-crystal silicon substrate, or an As-Ga substrate. At least an N-type semiconductor layer or a P-type semiconductor layer is formed on the substrate 10 (e.g. PN semiconductor). Preferably, an I-type semiconductor layer is disposed between the N-type semiconductor layer and the P-type semiconductor layer (e.g. PIN semiconductor).

The bus electrodes 12 are formed by separately disposing a conductive material on the substrate 10, and the finger electrodes 11 are formed by separately disposing a conductive material on the substrate 10 and at two sides of the bus electrodes 12. In this embodiment, the conductive material is usually a silver gel, which is mixture compound containing silver particles, organic solvent, organic binder, and glass powder. The glass powder usually includes oxide powder such as lead oxide, bismuth oxide, silicon oxide, etc.

The structure of the solar cell 1 of the present invention is described hereinabove, and the manufacturing method of the electrode structure of the solar cell 1 will be briefly illustrated hereinbelow.

FIG. 2 is a flow chart of a manufacturing method of the electrode structure of the solar cell 1 according to the embodiment of the present invention. The manufacturing method includes the steps S21 to S25, and the electrode structure of the solar cell, which includes a plurality of finger electrodes 11 and a plurality of bus electrodes 12, is described in the above embodiment, so the detailed description thereof will be omitted.

The step S21 is to provide a substrate 10, which is a semiconductor substrate treated by the front-end processes. For example, at least an N-type semiconductor layer or a P-type semiconductor layer is formed on the semiconductor substrate (e.g. PN semiconductor). Preferably, an 1-type semiconductor layer is disposed between the N-type semiconductor layer and the P-type semiconductor layer (e.g. PIN semiconductor).

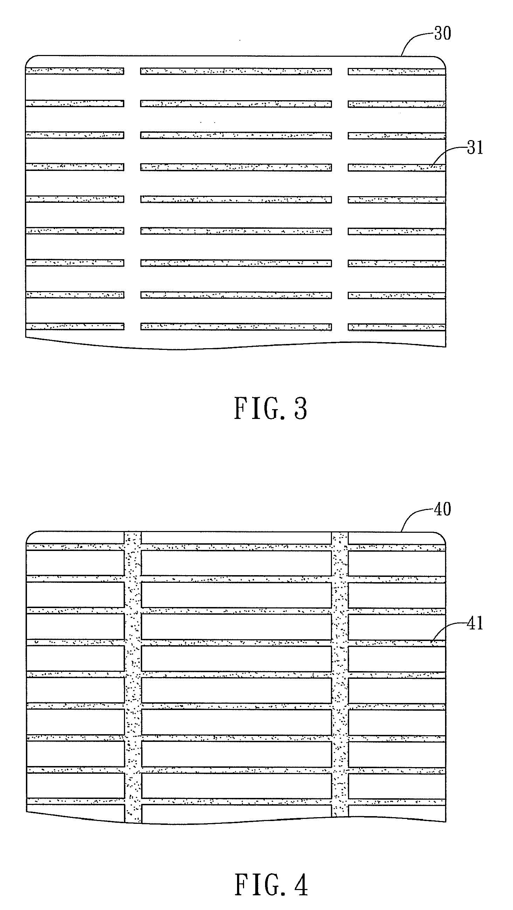

The step S22 is a first screen printing process for separately disposing a conductive material on the substrate 10 to form the bottom portions of a plurality of finger electrodes 11. FIG. 3 is a schematic diagram showing the screen 30 used in the first screen printing process. During the first screen printing process, the applied material can be formed on the substrate 10 through the separate areas 31, thereby forming the bottom portions of the finger electrodes 11.

The step S23 is to solidify the bottom portions of the finger electrodes 11 after the first screen printing process. In general, the step S23 can remove the volatile solvent in the printed materials. The solidification of the step S23 can be carried out by thermal solidification or light solidification, for example, by UV light. In this embodiment, the step S23 uses the thermal solidification to solidify the bottom portions of the finger electrodes 11. In more detailed, after the step S22, the substrate 10 is baked at 100 to 200 so as to remove the solvent without damaging the printed pattern.

The step S24 is a second screen printing process for separately disposing a conductive material on the substrate 10 to form a plurality of bus electrodes 12 and the top portions of the finger electrodes 11. FIG. 4 is a schematic diagram showing the screen 40 used in the second screen printing process. During the second screen printing process, the applied material can be formed on the substrate 10 through the separate areas 41, thereby forming the bus electrodes 12 and the top portions of the finger electrodes 11. Preferably, the material used in the first screen printing process is different from that used in the second screen printing process.

Preferably, the conductivity of the material used in the second screen printing process is larger than that of the material used in the first screen printing process. Preferably, the penetrability of the material used in the first screen printing process is larger than that of the material used in the second screen printing process.

The step S25 is to solidify the bus electrodes 12 and the top portions of the finger electrodes 11 after the second screen printing process. In general, the step S25 can remove the volatile solvent in the printed materials. The solidification of the step S25 can be carried out by thermal solidification or light solidification, for example, by UV light. In this embodiment, the solidification method of the step S25 is the same as that of the step S23 for solidifying the bottom portions of the finger electrodes 11.

To sum up, a first screen printing process forms the bottom portions of a plurality of finger electrodes. After solidifying the bottom portions of the finger electrodes, a second screen printing process forms the bus electrodes and the top portions of the finger electrodes and then solidifies the bus electrodes and the top portions of the finger electrodes. In the present invention, the first and second screen printing processes can form different patterns. Preferably, the material used in the first screen printing process is different from that used in the second screen printing process. In one embodiment of the present invention, the conductivity of the material used in the second screen printing process is larger than that of the material used in the first screen printing process. In addition, the penetrability of the material used in the first screen printing process is larger than that of the material used in the second screen printing process. Accordingly, the bottom portions of the finger electrodes formed by the first screen printing process can properly penetrate the anti-reflective layer of the substrate after high-temperature sintering, and the bus electrodes and the top portions of the finger electrodes formed by the second screen printing process can only contact with the anti-reflective layer of the substrate and not penetrate it. Compared with the conventional two screen printing processes that both form the same patterns of electrodes, the solar cell and the electrode structure of the present invention can have enhanced reliability against the environment and conductivity of the bus electrodes. The present invention can also decrease the defect of the solar cell. Thus, the purposes of increasing the photo-electro transition efficiency of the solar cell and decreasing the manufacturing cost thereof can be achieved.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. An electrode structure, which is disposed on a substrate of a solar cell, the electrode structure comprising:
a plurality of bus electrodes formed by separately disposing a conductive
material on the substrate; and
a plurality of finger electrodes formed by separately disposing a conductive
material on the substrate and at two sides of the bus electrodes;
wherein, the bus electrodes and the finger electrodes are formed by two screen
printing processes, the bottom portion of the finger electrodes are formed by a first screen printing process, and the top portion of the finger electrodes and the bus electrodes are formed by a second screen printing process.

2. The electrode structure of claim 1, wherein the material used in the first screen printing process is different from that used in the second screen printing process.

3. The electrode structure of claim 2, wherein the conductivity of the material used in the second screen printing process is larger than that of the material used in the first screen printing process.

4. The electrode structure of claim 2, wherein the penetrability of the material used in the first screen printing process is larger than that of the material used in the second screen printing process.

5. The electrode structure of claim 1, wherein the materials used in the first screen printing process and the second screen printing process comprise silver particles and glass powder.

6. A solar cell, comprising:
a substrate;
a plurality of bus electrodes formed by separately disposing a conductive
material on the substrate; and
a plurality of finger electrodes formed by separately disposing a conductive
material on the substrate and at two sides of the bus electrodes;
wherein, the bus electrodes and the finger electrodes are formed by two screen
printing processes, the bottom portion of the finger electrodes are formed by a first screen printing process, and the top portion of the finger electrodes and the bus electrodes are formed by a second screen printing process.

7. The solar cell of claim 6, wherein the material used in the first screen printing process is different from that used in the second screen printing process.

8. The solar cell of claim 7, wherein the conductivity of the material used in the second screen printing process is larger than that of the material used in the first screen printing process.

9. The solar cell of claim 7, wherein the penetrability of the material used in the first screen printing process is larger than that of the material used in the second screen printing process.

10. The solar cell of claim 6, wherein the materials used in the first screen printing process and the second screen printing process comprise silver particles and glass powder.

11. The solar cell of claim 6, wherein the substrate is an amorphous silicon substrate, a single-crystal silicon substrate, a poly-crystal silicon substrate, or an As-Ga substrate.

12. The solar cell of claim 6, wherein the substrate is an N-type semiconductor substrate or a P-type semiconductor substrate.
